# FASCICULE DE BREVET EUROPEEN

(11) **EP 4 113 586 B1**
(45) Date de publication et mention de la délivrance du brevet: **24.04.2024**
(21) Numéro de dépôt: 22181755.4
(22) Date de dépôt: 29.06.2022
(51) Int. Cl.: H01L 21/673

(54) **DISPOSITIF D'IMMERSION DE PLAQUETTES**
PLÄTTCHENEINTAUCHVORRICHTUNG
WAFER IMMERSION DEVICE

(30) Priorité: 02.07.2021 FR 2107192
(43) Date de publication de la demande: 04.01.2023
(73) Titulaire: Commissariat à l'énergie atomique et aux énergies alternatives, 75015 Paris (FR)
(72) Inventeur: LIGNIER, Hélène, 38054 Grenoble cedex 09 (FR); DUBOIS, Sébastien, 38054 Grenoble cedex 09 (FR)
(74) Mandataire: Cabinet Nony

(56) Documents cités:
- DE-A1-102007 016 388
- JP-A- H06 112 176
- US-A- 6 138 695

## Description

### Domaine technique

La présente invention concerne l'immersion de plaquettes, notamment durant le processus de fabrication de cellules photovoltaïques.

Classiquement, une cellule photovoltaïque comporte une plaquette, communément dénommée « *wafer »* en anglais, qui présente une forme de pavé droit de faible épaisseur. La plaquette est composée d'un matériau semi-conducteur, généralement du silicium. La fabrication d'une telle cellule photovoltaïque peut nécessiter l'immersion de la plaquette au cours du processus de fabrication dans un bain.

En effet, il peut être par exemple nécessaire de plonger les plaquettes dans une solution chimique basique afin de graver leurs surfaces par voie chimique pour retirer la zone écrouie lors de leur découpage.

Il peut s'agir d'un bain de KOH, par exemple à 80°C, selon la réaction suivante : Si + 2KOH + H₂O -> K₂SiO₄ + 2H₂.

Pendant cette phase d'immersion dans un bain de solution basique, il peut être nécessaire de maintenir les plaquettes dans la solution au moyen d'un dispositif d'immersion. En effet, lors de cette phase d'immersion, de l'hydrogène est dégagé, pouvant engendrer une réaction importante et une production de bulles de gaz, conduisant à une remontée des plaquettes à la surface du bain, les bulles de gaz se formant en surface de la plaquette. Ce phénomène est d'autant plus important lorsque, les plaquettes étant découpées, leur masse peut être réduite.

Au cours du processus de fabrication d'une cellule photovoltaïque, et de manière plus générale, il peut être nécessaire de maintenir les plaquettes dans un dispositif d'immersion lors de différents procédés chimique, afin de contrer d'autres phénomènes en présence tels que la poussée d'Archimède, plus ou moins importante en fonction de la densité du mélange, ou encore une recirculation de la solution chimique dans le bain venant générer des turbulences.

### Technique antérieure

Les systèmes d'immersion connus ont une taille standard dépendante de la taille standard des plaquettes à immerger. Les plaquettes y sont en général maintenues en sept points correspondant à sept barres de maintien, à savoir deux dans le fond, quatre latérales, avec deux de chaque côté, et une supérieure centrale.

Afin d'accroitre la puissance des modules photovoltaïques et de pouvoir intégrer plus facilement les plaquettes photovoltaïques au sein de ces modules photovoltaïques, différents formats de plaquettes peuvent être utilisés. A cet effet, on peut découper les plaquettes de tailles standard en plusieurs morceaux, du sixième de plaquette à la demi-plaquette.

Ainsi, la découpe des plaquettes en début de fabrication des cellules photovoltaïques peut se révéler avantageuse.

Cependant, lorsque l'on découpe les plaquettes, ce qui a lieu en principe après l'ensemble du procédé de fabrication des plaquettes standard, la passivation de surface des zones découpées se trouve fortement dégradée.

Des solutions de re-passivation des bords peuvent être mises en oeuvre pour certaines technologies mais ces solutions ne sont pas toujours adaptées à d'autres technologies de plaquettes telles que la technologie de cellules photovoltaïques de type hétérojonction. En outre, ces solutions de re-passivation des bords constituent une étape supplémentaire à réaliser et génèrent donc un coût additionnel au module final.

Il est alors possible, pour éviter les soucis évoqués ci-dessus, de découper les plaquettes puis d'effectuer l'étape de traitement chimique permettant de graver les surfaces et ainsi retirer la zone écrouie

Toutefois, lorsque l'on découpe les différentes plaquettes de formats standards en 2, 3, 4 ou 6 morceaux, on obtient une variété très importante de dimensions possibles, ce qui est problématique pour l'installation desdites plaquettes dans les dispositifs d'immersion disponibles. En effet, pour une dimension donnée de plaquette standard, il faudrait ainsi un dispositif d'immersion adapté pour chaque format de plaquette découpée en morceau.

Une taille standard de plaquette peut par exemple aller d'un carré de 156,75 mm de côté, dite taille M2, à un carré de 210 mm de côté, dite taille M12.

Les dispositifs d'immersion pour plaquette standard entière permettent en effet de maintenir les plaquettes dans les bains contenant les solutions chimiques via une barre de maintien supérieure pour éviter qu'elles ne s'échappent. Si la plaquette est découpée, elle n'est alors plus maintenue correctement par la barre supérieure, et est susceptible de bouger dans le dispositif d'immersion et donc de s'échapper de celui-ci ou de se coller à aux plaquettes adjacentes, ce qui est préjudiciable au procédé. Il est donc nécessaire de pouvoir maintenir les morceaux de plaquettes dans le dispositif d'immersion de manière satisfaisante

DE 10 2007 016388 A1 divulgue un dispositif d'immersion de plaquettes selon l'art antérieur.

Il existe donc un besoin pour améliorer les dispositifs d'immersion afin de permettre d'y maintenir des plaquettes de formats variés, par exemple dans le cas où une plaquette de taille standard a été découpée en plusieurs morceaux.

La présente invention vise à répondre à ce besoin.

### Résumé de l'invention

L'invention a ainsi pour objet, selon l'un de ses aspects, un dispositif de d'immersion de plaquettes P, comportant deux flasques d'extrémité portant des barres de maintien des plaquettes, chaque flasque d'extrémité comportant au moins une rainure pour recevoir au moins une barre de maintien modulable configurée pour être positionnée à une hauteur réglable par coulissement dans les rainures des deux flasques.

La ou les barres de maintien modulable comportent chacune deux rangées opposées de dents de séparation des plaquettes.

Par « plaquette », autrement dénommée « wafer » en anglais, on désigne un substrat ayant une forme de pavé droit de faible épaisseur, formé à partir d'un matériau semi-conducteur, généralement du silicium et plus particulièrement du silicium cristallin. L'épaisseur de la plaquette peut être comprise entre 100 et 400 µm, par exemple de l'ordre de 180 µm.

Le dispositif d'immersion selon l'invention permet d'accueillir des plaquettes de tailles différentes, grâce au réglage en hauteur de la barre de maintien modulable, ce qui est notamment utile dans le cas où une plaquette de taille standard a été découpée en plusieurs morceaux.

La barre de maintien modulable permet, par son coulissement dans les rainures des flasques d'extrémité, d'être adaptée ainsi à différentes hauteurs de plaquettes pour maintenir celles-ci.

La présence des rainures dans les flasques d'extrémité n'entrave pas leur solidité ni la possibilité de préhension du dispositif d'immersion par un robot.

Le dispositif d'immersion selon l'invention peut ainsi comporter sept ou huit points de contact et de maintien pour les plaquettes.

La ou les barres de maintien modulables supplémentaires peuvent notamment comporter une première rangée de dents pour séparer une rangée de plaquettes inférieures dans le dispositif, et une deuxième rangée de dents pour séparer une rangée de plaquettes supérieure dans le dispositif.

Ainsi, l'invention permet également d'empiler plusieurs morceaux de plaquettes, ce qui peut permettre de traiter simultanément un plus grand nombre de plaquettes et donc de conserver voire même d'améliorer la cadence de traitement dans l'équipement de chimie, en dépit de l'utilisation de plaquettes découpées.

En outre, le dispositif selon l'invention permet de s'adapter aux équipements industriels de chimie utilisés habituellement pour la fabrication des cellules photovoltaïques. Les premières étapes de fabrication des cellules comportent notamment une gravure de la zone écrouie suivie d'une texturation des surfaces puis d'un nettoyage de celles-ci.

Le dispositif selon l'invention peut être fabriqué à partir d'un dispositif d'immersion standard conçu pour des plaquettes d'un format de taille standard, par exemple un format de plaquettes de type M2, c'est-à-dire de plaquettes de 156,75 mm de côté. Il permet, à partir d'un dispositif d'immersion standard disponible commercialement, d'avoir un unique dispositif d'immersion permettant d'accueillir des quarts, tiers ou demi-plaquettes pour chaque format de plaquette standard.

### Exposé de l'invention

Les barres de maintien peuvent être dentelées, pouvant comporter chacune une unique rangée de dents de séparation des plaquettes. La ou les barres de maintien modulable comportent chacune deux rangées opposées de dents de séparation des plaquettes.

Les dents de séparation ménagent entre elles des fentes de réception des plaquettes. Chaque fente est destinée à recevoir une plaquette, afin d'éviter tout contact entre deux plaquettes différentes. La rangée de dents permet de bien séparer chaque plaquette de la ou des plaquettes adjacentes, afin d'éviter tout contact entre les plaquettes, et de bien favoriser la circulation du fluide dans lequel peuvent être immergées les plaquettes dans le dispositif d'immersion selon l'invention.

La largeur d'une dent peut correspondre à l'écartement entre deux plaquettes consécutives. La largeur d'une dent peut par exemple être choisie dans la liste suivante, qui n'est pas limitative : 4,76 mm, par exemple pour des plaquettes de taille M2, ou 6,3 mm, par exemple pour des plaquettes de taille M12. La largeur d'une dent peut dépendre du format des plaquettes. Cette largeur peut ainsi conditionner le nombre de plaquettes pour une même longueur de dispositif d'immersion.

L'écartement entre deux dents consécutives peut par exemple être choisi dans la liste suivante, qui n'est pas limitative : 4,76 mm, par exemple pour des plaquettes de taille M2, ou 6,3 mm, par exemple pour des plaquettes de taille M12. La largeur d'une dent peut dépendre de la largeur initiale des plaquettes. En effet, si les plaquettes sont plus larges, leur déformation peut être plus importante, et il y a donc plus de risques de collage de celle-ci lors des traitements chimiques.

Les dents peuvent avoir une longueur d'environ 10 mm.

La barre de maintien modulable peut par exemple avoir une épaisseur de l'ordre de 16 mm.

La rainure peut avoir une largeur de l'ordre de 17 mm.

La rainure peut avoir une hauteur, mesurée depuis le fond de la rainure jusqu'à son ouverture en haut du flasque, de l'ordre de 170 mm.

Chaque flasque d'extrémité peut comporter une seule rainure. Une telle configuration avec une seule rainure par flasque permet avantageusement d'améliorer la tenue mécanique du flasque, et celle du dispositif résultant.

La rainure unique d'un flasque peut être centrale, étant par exemple disposée sur un axe de symétrie du flasque. La rainure unique peut par exemple être disposée dans le prolongement d'un logement destiné à recevoir une barre de maintien placée en position supérieure au-dessus des plaquettes, ce qui peut permettre de simplifier la fabrication des flasques.

Une telle configuration est particulièrement adaptée pour un dispositif destiné à recevoir des plaquettes suffisamment grandes, par exemple des demie ou tiers de plaquettes de taille standard.

Une taille standard est par exemple choisie dans la liste suivante, qui n'est pas limitative : de forme carrée ou sensiblement carrée, avec un côté de longueur choisie dans la liste suivante, en millimètres (mm) : 210 (dit M12), 200 (dit M10), 192 (dit M9), 166 (dit M6), 161,7 (dit M4), 158,75 (dit G1), 156,75 (dit M12), cette liste n'étant pas limitative.

En variante, chaque flasque d'extrémité peut comporter plusieurs rainures, notamment deux rainures.

Le dispositif d'immersion selon l'invention peut ainsi comporter au moins huit points de contact et de maintien pour les plaquettes.

Ainsi, le dispositif peut comporter une seule ou plusieurs barres de maintien modulables, par exemple deux. Le dispositif peut notamment comporter une seule ou plusieurs barres de maintien modulables par rainure, par exemple deux par rainure.

Chaque rainure peut recevoir au moins une barre de maintien modulable, notamment une ou deux. Chaque rainure peut également recevoir, additionnellement, une barre de maintien. Ladite barre de maintien reçu dans la rainure peut comporter une seule rangée de dents de séparation des plaquettes. Elle peut être disposer dans le haut de la rainure, au-dessus de la rangée supérieure de plaquettes.

Le dispositif peut être configuré pour recevoir une pluralité de rangées de plaquettes, notamment deux, trois ou quatre, par exemple deux ou trois.

Le dispositif selon l'invention peut notamment être configuré pour recevoir plus d'une rangée de plaquettes. Il peut par exemple en recevoir deux, voire plus, par exemple trois ou quatre.

Le dispositif peut également être configuré pour recevoir une unique rangée de plaquettes, mais des plaquettes de taille inférieure à la taille standard.

Les rangées de plaquettes reçues dans le dispositif peuvent notamment être superposées verticalement l'une sur l'autre ou les unes sur les autres. Le dispositif peut notamment recevoir une rangée inférieure et une rangée supérieure, ou en variante une rangée inférieure, une ou plusieurs rangées centrales et une rangée supérieure.

Une telle configuration permet d'assurer une cadence d'immersion élevée.

Les plaquettes peuvent résulter du découpage de plaquettes de taille standard. Par exemple, les plaquettes peuvent résulter du découpage en 2, en 3, en 4, ou en 6 d'une plaquette de taille standard.

Une plaquette de taille standard peut être carrée ou sensiblement carrée. Elle peut avoir un côté de longueur choisie dans la liste suivante, en millimètres (mm) : 210, 200, 192, 166, 161,7, 158,75, 156,75, cette liste n'étant pas limitative.

Compte tenu de l'espace nécessaire aux barres de maintien supplémentaire, le dispositif peut être configuré pour recevoir une plaquette coupée en deux, deux plaquettes coupées en trois, trois plaquettes coupées en quatre ou quatre plaquettes coupées en six, par exemple.

Les plaquettes résultant du découpage de plaquettes de taille standard sont de forme rectangulaire. Elles peuvent avoir une largeur correspondant à la largeur de la plaquette de taille standard initiale, listée ci-dessus, et une hauteur choisie dans la liste suivante, en millimètres (mm) : 210/2, 210/3, 210/4, 210/6, 200/0, 200/2, 200/4, 200/6, 192/2, 192/3, 192/4, 192/6, 166/2, 166/3, 166/4, 166/6, 161,7/2, 161,7/3, 161,7/4, 161,7/6, 158,75/2, 158,75/3, 158,75/4, 158,75/6, 156,75/2, 156,75/3, 156,75/4, 156,75/6, cette liste n'étant pas limitative.

Une rangée de plaquettes peut comporter entre 10 et 500 plaquettes, par exemple entre 20 et 200 plaquettes, notamment 50, 75 ou 100 plaquettes.

Un panier a par exemple une longueur fixe permettant de loger 100 plaquettes pour un format de type M2 ou par exemple 80 plaquettes de format de type M12.

Avant traitement chimique, la masse d'une plaquette non découpée peut être comprise entre 7 et 14 g par exemple pour une largeur de 156 mm, mieux entre 9 et 11 g. L'épaisseur de la plaquette peut être comprise entre 140 et 250 µm, étant par exemple de 160 µm.

Le dispositif peut comporter des barres de maintien latérales, notamment deux groupes de barres de maintien latérales, un de chaque côté des plaquettes reçues dans le dispositif. Les barres de maintien latérales peuvent comporter une seule rangée de dents de séparation des plaquettes.

Un groupe de barres de maintien latérales peut comporter au moins deux barres de maintien latérales, notamment deux ou trois.

Lorsque le groupe comporte trois barres de maintien latérales, il peut comporter une barre latérale centrale disposée à mi-hauteur du flasque. Une telle configuration avec trois barres de maintien latérales de chaque côté peut être avantageuse dans le cas où le dispositif reçoit une pluralité de rangées de plaquettes. En effet, la barre de maintien latérale centrale peut permettre de maintenir à la fois la rangée inférieure et la rangée supérieure, dont le maintien peut ainsi être amélioré. Ladite barre de maintien latérale centrale peut comporter une seule rangée de dents de séparation des plaquettes ou en variante deux rangées de dents.

Le dispositif peut comporter des barres de maintien inférieures, notamment deux, placées en position inférieure en-dessous des plaquettes, afin de supporter celles-ci. Les barres de maintien inférieures peuvent comporter une seule rangée de dents de séparation des plaquettes.

Le dispositif peut comporter au moins une barre de maintien supérieure, notamment une ou deux, placée en position supérieure au-dessus des plaquettes, afin de maintenir celles-ci. La ou les barres de maintien supérieures peuvent comporter une seule rangée de dents de séparation des plaquettes.

La ou les barres de maintien supérieures peuvent être configurées pour reposer sur les plaquettes. Elles peuvent comporter une butée d'extrémité, laquelle peut être de forme ovoïde. La forme ovoïde permet le maintien de la barre de maintien supérieure par une légère rotation de celle-ci. La rotation peut être effectuée après chargement des plaquettes dans le dispositif. La rangée de dents peut être décalée d'un angle d'environ 120° par rapport à un sommet de la forme ovoïde.

Les barres de maintien latérales et inférieures peuvent être fixé aux flasques d'extrémité par des écrous fixés à la barre de maintien correspondante à l'extérieur de chaque flasque d'extrémité. A cet effet, les barres de maintien comportent des extrémités filetées pour recevoir lesdits écrous. Les barres de maintien et les écrous peuvent être inertes chimiquement.

La ou les barres de maintien modulables peuvent être configurées pour reposer sur les plaquettes en étant maintenues aux flasques d'extrémité par une butée d'extrémité, laquelle peut être de forme ovoïde. La forme ovoïde permet le maintien de la barre de maintien modulable par une légère rotation de celle-ci dans la rainure. La rotation peut être effectuée après chargement des plaquettes dans le dispositif.

En variante, la ou les barres de maintien modulables peut être fixées aux flasques d'extrémité par un organe de fixation.

Ainsi, la barre de maintien modulable peut être immobilisée à la hauteur souhaitée dans la rainure, sans reposer sur les plaquettes. Cette solution est particulièrement avantageuse pour des plaquettes présentant une tenue mécanique moindre, c'est-à-dire très fine, par exemple d'épaisseur inférieure à 120 µm ou de hauteur petit, par exemple dans le cas où la plaquette résulte du découpage d'une plaquette standard en plus de 4 morceaux, notamment en plus de 6 morceaux.

L'organe de fixation peut comporter dans un mode de réalisation un écrou fixé à la ou les barres de maintien modulables à l'extérieur du flasque d'extrémité correspondant. A cet effet, les barres de maintien modulables comportent des extrémités filetées pour recevoir lesdits écrous.

Dans un autre mode de réalisation, l'organe de fixation peut comporter une vis papillon fixée à la ou les barres de maintien modulables à l'extérieur du flasque d'extrémité correspondant. A cet effet, les barres de maintien modulables comportent des extrémités filetées pour recevoir lesdites vis papillon. La vis papillon peut être réalisée dans un matériau inerte, par exemple de type PFA. La vis papillon peut dépasser du flasque d'une distance maximum de 10 mm, afin de ne pas générer de surépaisseur trop importante, laquelle pourrait gêner la préhension par un robot du dispositif d'immersion.

Les barres de maintien peuvent comporter une âme entourée d'un revêtement, l'âme étant notamment en acier inoxydable. Le revêtement permet d'éviter toute contamination métallique. Aucune surface métallique peut n'être exposée à l'extérieur. Ce revêtement peut être réalisée dans un matériau polymère. Dans un mode de réalisation, le revêtement des barres de maintien est réalisé en PVDF chargé avec une charge de fibres de carbone.

Les flasques d'extrémité peuvent comporter du PVDF. Dans un mode de réalisation, les flasques d'extrémité sont entièrement réalisés en PVDF.

Les flasques d'extrémité peuvent être de forme rectangulaire ou carrée. Ils peuvent avoir une largeur choisie dans la liste suivante, en millimètres (mm) : 260, 250, 242, 216, 211,7, 208,75, 206,75, cette liste n'étant pas limitative. Ils peuvent avoir une hauteur choisie dans la liste suivante, en millimètres (mm) : 260, 250, 242, 216, 211,7, 208,75, 206,75, cette liste n'étant pas limitative. Dans un exemple de réalisation, la hauteur d'un flasque d'extrémité peut par exemple être de l'ordre de 206 mm. Il peut avoir une largeur de l'ordre de 206 mm.

Les flasques d'extrémité peuvent être configurés pour permettre leur préhension automatique au moyen d'un robot de chargement et de déchargement.

La longueur du dispositif peut par exemple être environ de 274 mm, par exemple pour une capacité de 50 plaquettes de tailles voisines de M2 et pour une épaisseur de l'ordre de 180 µm pour une rangée, ou de 554 mm, par exemple pour une capacité de 100 plaquettes de tailles voisines de M2 et pour une épaisseur de l'ordre de 180 µm.

Le dispositif peut être intégré dans une ligne de fabrication de cellules photovoltaïques.

L'invention a encore pour objet, un procédé de remplissage tel que définit dans la revendication 14.

### Brève description des dessins

L'invention pourra être mieux comprise à la lecture de la description détaillée qui va suivre, d'exemples de réalisation non limitatifs de celle-ci, et à l'examen du dessin annexé, sur lequel :
[Fig 1] La figure 1 est une vue de face d'un flasque de dispositif d'immersion conforme à l'invention.
[Fig 2] La figure 2 représente le dispositif de la figure 1 recevant des plaquettes.
[Fig 3] La figure 3 est une vue en perspective, schématique et partielle, du dispositif de la figure 1.
[Fig 4] La figure 4 est une vue en perspective, schématique et partielle, d'une variante de réalisation.
[Fig 5] La figure 5 est une vue en perspective, schématique et partielle, d'une variante de réalisation.
[Fig 6] La figure 6 est une vue de détails, en perspective, schématique et partielle, du dispositif de la figure 1.
[Fig 7a] La figure 7a est une vue de détails, de côté, schématique et partielle, du dispositif de la figure 1.
[Fig 7b] La figure 7b est une vue de détails, de côté, schématique et partielle, du dispositif de la figure 1.
[Fig 8] La figure 8 est une vue de côté, schématique et partielle, d'une variante de réalisation.

### Description détaillée

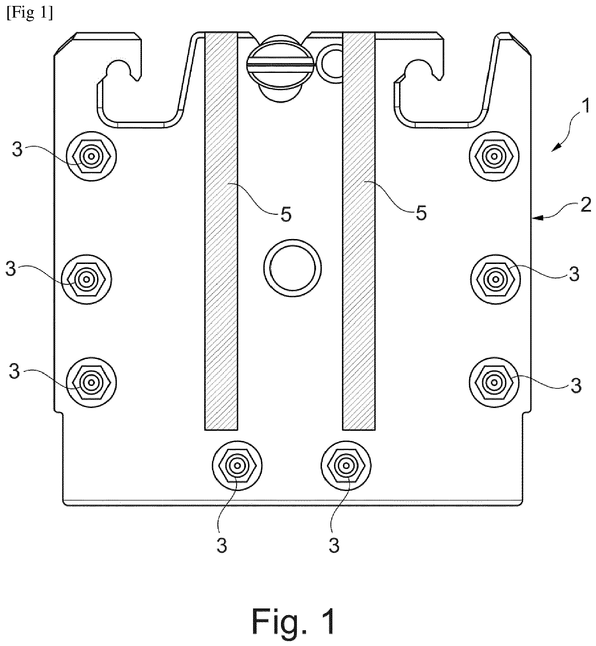

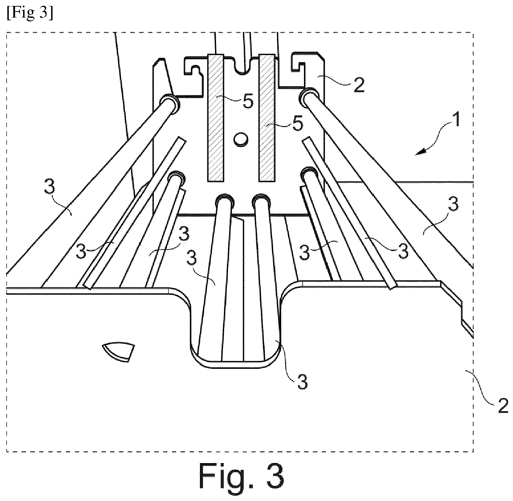

On a illustré aux figures 1 à 3 un dispositif d'immersion 1 de plaquettes P qui comporte deux flasques d'extrémité 2 portant des barres de maintien 3 des plaquettes P. La hauteur d'un flasque d'extrémité est de l'ordre de 206 mm et sa largeur de l'ordre de 206 mm.

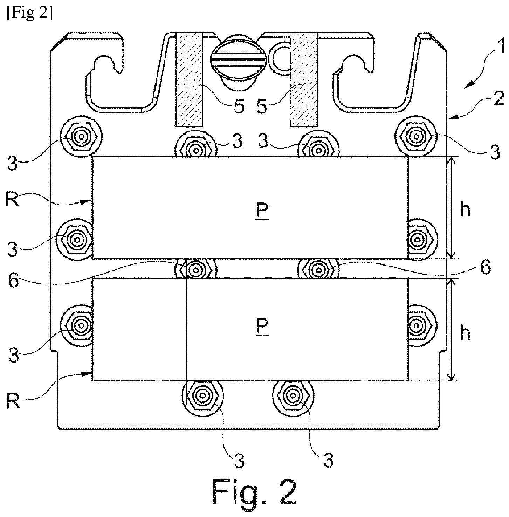

Chaque flasque d'extrémité 2 comporte deux rainures 5 pour recevoir au moins une barre de maintien modulable 6 configurée pour être positionnée à une hauteur réglable par coulissement dans les rainures 5 des deux flasques, comme visible sur la figure 2.

Le dispositif d'immersion selon l'invention permet d'accueillir des plaquettes P de tailles différentes, grâce au réglage en hauteur de la barre de maintien modulable. La barre de maintien modulable permet, par son coulissement dans les rainures des flasques d'extrémité, d'être adaptée ainsi à différentes hauteurs de plaquettes pour maintenir celles-ci.

Comme visible sur la figure 2, chaque plaquette est maintenue par huit points de contact.

Dans l'exemple décrit, le dispositif d'immersion est destiné à recevoir des tiers de plaquettes de taille standard, disposés en deux rangées R superposées. Les plaquettes P résultent du découpage en trois de plaquettes de taille standard de forme carrée ou quasi carrée, de côté de longueur 156,75 mm. Les plaquettes P ont dans l'exemple décrit une hauteur h de 52,25 mm.

Les rangées R de plaquettes P reçues dans le dispositif sont superposées verticalement l'une sur l'autre. Le dispositif reçoit ainsi une rangée inférieure et une rangée supérieure.

Dans l'exemple de réalisation décrit, chaque flasque d'extrémité 2 comporte deux rainures 5. Ainsi, le dispositif d'immersion 1 peut comporter au moins deux barres de maintien modulables 6. En particulier, chaque rainure 5 reçoit une barre de maintien modulable 6, comme illustré sur la figure 2. Chaque rainure 5 reçoit également, additionnellement, une barre de maintien 3, disposée dans le haut de la rainure, au-dessus de la rangée R supérieure de plaquettes.

Les deux rainures sont dans l'exemple décrit écartées l'une de l'autre de 54 mm et des bords latéraux du flasque de 60 mm. Elles mesurent 170 mm de haut, et sont écartées du bord inférieur du flasque de 36 mm.

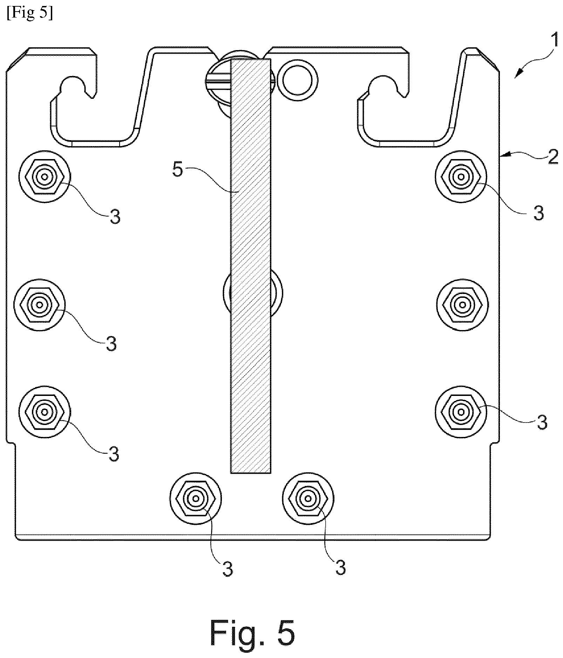

En variante, chaque flasque d'extrémité peut comporter une seule rainure 5, comme illustré à la figure 5. Dans ce mode de réalisation, la rainure 5 unique est centrale, étant disposée sur un axe de symétrie du flasque 2. Une telle configuration avec une seule rainure par flasque permet avantageusement d'améliorer la tenue mécanique du flasque, et celle du dispositif résultant. La rainure 5 unique est par exemple écartée des bords latéraux du flasque 2 de 90 ou 100 mm.

L'ensemble des barres de maintien 3 comporte des barres de maintien 3 latérales, en particulier deux groupes de barres de maintien latérales, un de chaque côté des plaquettes reçues dans le dispositif. Un groupe de barres de maintien latérales comportant ici trois barres de maintien latérales, comme illustré, dont une barre latérale centrale disposée à mi-hauteur du flasque.

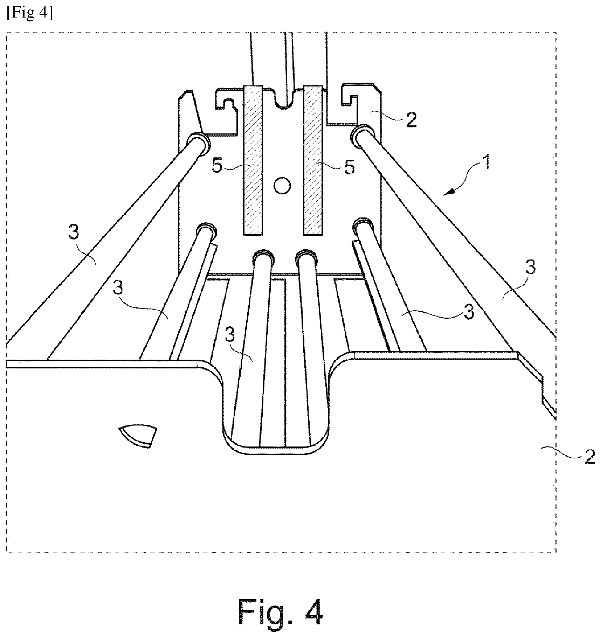

En variante, un groupe de barres de maintien 3 latérales peut comporter deux barres de maintien 3 latérales, comme illustré à la figure 4.

L'ensemble des barres de maintien 3 comporte également des barres de maintien 3 inférieures, ici deux, placées en position inférieure en-dessous des plaquettes P, afin de supporter celles-ci, ainsi que deux barres de maintien 3 supérieure, placées en position supérieure au-dessus des plaquettes P, afin de maintenir celles-ci.

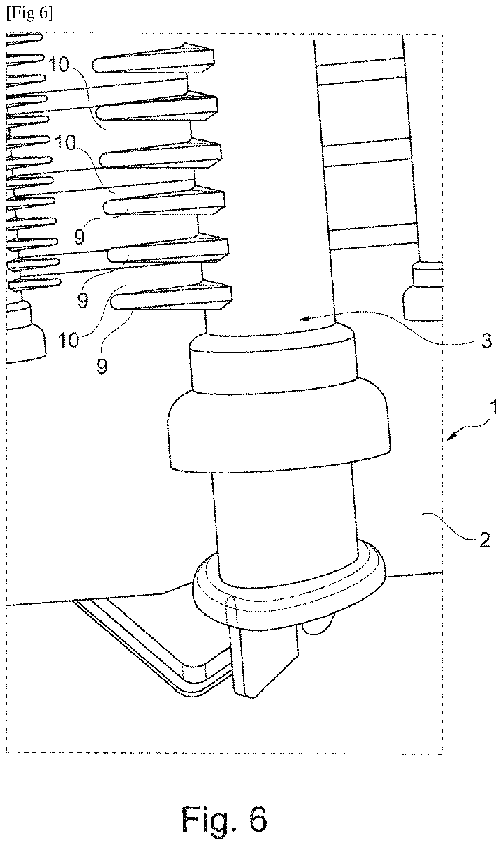

Par ailleurs, les barres de maintien sont dentelées, comme illustré à la figure 6.

Les barres de maintien 3 peuvent comporter chacune une unique rangée de dents 9 de séparation des plaquettes. En particulier, les barres de maintien latérales peuvent comporter une seule rangée de dents de séparation des plaquettes. Les barres de maintien inférieures peuvent comporter une seule rangée de dents de séparation des plaquettes. La ou les barres de maintien supérieures peuvent comporter une seule rangée de dents de séparation des plaquettes.

En revanche, la ou les barres de maintien modulable 6 comportent chacune deux rangées opposées de dents de séparation des plaquettes, avec une première rangée de dents pour séparer une rangée R de plaquettes inférieures dans le dispositif, et une deuxième rangée de dents pour séparer une rangée R de plaquettes supérieure dans le dispositif.

Les dents 9 de séparation ménagent entre elles des fentes 10 de réception des plaquettes P. Chaque fente 10 est destinée à recevoir une plaquette P, afin d'éviter tout contact entre deux plaquettes différentes.

La largeur d'une dent peut correspondre à l'écartement entre deux plaquettes consécutives. La largeur d'une dent peut par exemple être choisie dans la liste suivante, qui n'est pas limitative : 4,76 mm, 6,3 mm.

Les dents 9 peuvent avoir une longueur d'environ 10 mm.

La barre de maintien modulable 6 peut par exemple avoir une épaisseur de l'ordre de 16 mm.

La rainure 5 peut avoir une largeur de l'ordre de 17 mm.

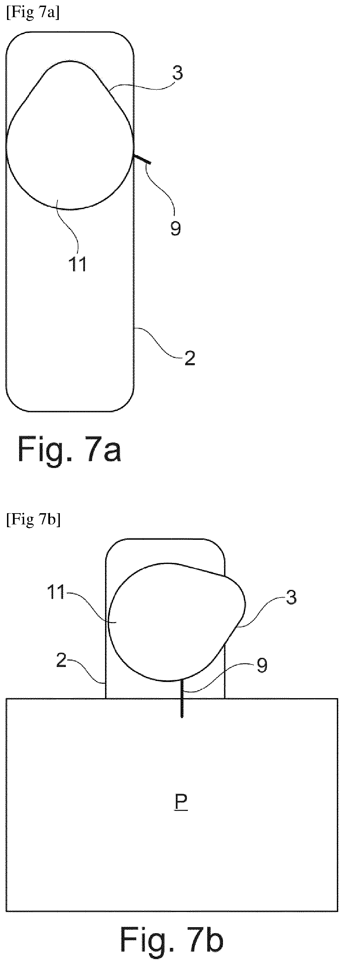

La ou les barres de maintien 3 supérieures sont configurées pour reposer sur les plaquettes. Elles comportent une butée d'extrémité 11 de forme ovoïde. La forme ovoïde permet le maintien de la barre de maintien 3 supérieure par une légère rotation de celle-ci. La rotation peut être effectuée après chargement des plaquettes P dans le dispositif. La rangée de dents peut être décalée d'un angle d'environ 120° par rapport à un sommet de la forme ovoïde, comme visible aux figures 7a et 7b.

Les barres de maintien 3 latérales et inférieures sont fixé aux flasques d'extrémité par des écrous fixés à la barre de maintien correspondante à l'extérieur de chaque flasque d'extrémité. A cet effet, les barres de maintien comportent des extrémités filetées pour recevoir lesdits écrous.

En ce qui concerne la ou les barres de maintien modulables 6, elles peuvent être configurées pour reposer sur les plaquettes en étant maintenues aux flasques d'extrémité par une butée d'extrémité 11, laquelle peut être de forme ovoïde, de manière analogue à ce qui est illustré aux figures 7a et 7b pour les barres de maintien 3 supérieures.

La forme ovoïde permet le maintien de la barre de maintien modulable par une légère rotation de celle-ci dans la rainure. La rotation peut être effectuée après chargement des plaquettes dans le dispositif.

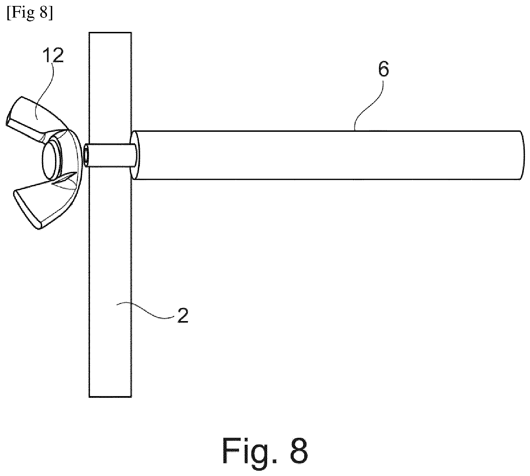

En variante, la ou les barres de maintien modulables sont fixées aux flasques d'extrémité par un organe de fixation, comme illustré à la figure 8. Ainsi, la barre de maintien modulable peut être immobilisée à la hauteur souhaitée dans la rainure, sans reposer sur les plaquettes.

Dans l'exemple illustré à la figure 8, l'organe de fixation comporte une vis papillon 12 fixée à la ou les barres de maintien modulables 6 à l'extérieur du flasque 2 d'extrémité correspondant. A cet effet, les barres de maintien modulables 6 comportent des extrémités filetées pour recevoir lesdites vis papillon. La vis papillon peut être réalisée dans un matériau inerte, par exemple de type PFA. La vis papillon peut dépasser du flasque d'une distance maximum de 10 mm, afin de ne pas générer de surépaisseur trop importante, laquelle pourrait gêner la préhension par un robot du dispositif d'immersion.

En variante, l'organe de fixation peut comporter dans un autre mode de réalisation un écrou fixé à la ou les barres de maintien modulables à l'extérieur du flasque d'extrémité correspondant. A cet effet, les barres de maintien modulables comportent des extrémités filetées pour recevoir lesdits écrous.

## Revendications

1. Dispositif d'immersion (1) de plaquettes (P), comportant des barres de maintien (3) des plaquettes, au moins une barre de maintien modulable (6) ainsi que deux flasques d'extrémité (2) portant lesdites barres de maintien (3) des plaquettes, chaque flasque d'extrémité (2) comportant au moins une rainure (5) pour recevoir ladite au moins une barre de maintien modulable (6) configurée pour être positionnée à une hauteur réglable par coulissement dans les rainures (5) des deux flasques, **caractérisé en ce que** ladite au moins une barre de maintien modulable (6) comporte chacune deux rangées opposées de dents (9) de séparation des plaquettes.

2. Dispositif selon la revendication précédente, les barres de maintien (3) sont dentelées, comportant chacune une unique rangée de dents (9) de séparation des plaquettes.

3. Dispositif selon l'une quelconque des revendications précédentes, chaque flasque d'extrémité (2) comportant une seule rainure (5).

4. Dispositif selon l'une quelconque des revendications précédentes, chaque flasque d'extrémité (2) comportant plusieurs rainures (5), notamment deux rainures (5).

5. Dispositif selon l'une quelconque des revendications précédentes, configuré pour recevoir une pluralité de rangées (R) de plaquettes (P), notamment deux, trois ou quatre.

6. Dispositif selon l'une quelconque des revendications précédentes, comportant des barres de maintien (3) latérales, notamment deux groupes de barres de maintien latérales, un de chaque côté des plaquettes (P) reçues dans le dispositif (1).

7. Dispositif selon la revendication précédente, un groupe de barres de maintien (3) latérales comportant au moins deux barres de maintien (3) latérales, notamment deux ou trois.

8. Dispositif selon l'une quelconque des revendications précédentes, comportant des barres de maintien (3) inférieures, notamment deux, placées en position inférieure en-dessous des plaquettes, afin de supporter celles-ci.

9. Dispositif selon l'une quelconque des revendications précédentes, comportant au moins une barre de maintien (3) supérieure, notamment une ou deux, placée en position supérieure au-dessus des plaquettes (P), afin de maintenir celles-ci.

10. Dispositif selon l'une quelconque des revendications précédentes, la ou les barres de maintien modulables (6) étant configurées pour reposer sur les plaquettes (P) en étant maintenues aux flasques d'extrémité (2) par une butée d'extrémité (11), laquelle peut être de forme ovoïde.

11. Dispositif selon l'une quelconque des revendications précédentes, la ou les barres de maintien modulables (6) étant fixées aux flasques d'extrémité (2) par un organe de fixation (12).

12. Dispositif selon l'une quelconque des revendications précédentes, les barres de maintien (3) comportent une âme entourée d'un revêtement, l'âme étant notamment en acier inoxydable.

13. Dispositif selon l'une quelconque des revendications précédentes, dans lequel les flasques d'extrémité (2) comportent du PVDF.

14. Procédé de remplissage d'un dispositif d'immersion (1), selon l'une quelconque des revendications précédentes, dans lequel :
(i) on place une première rangée (R) de plaquettes (P) dans le dispositif d'immersion (1),
(ii) on place au moins une barre de maintien modulable (6), comportant au moins deux rangées de dents (9), par-dessus la première rangée (R) de plaquettes (P), et
(iii) on place une deuxième rangée (R) de plaquettes (P) dans le dispositif d'immersion (1) par-dessus la ou les barres de maintien modulable (6).

## Patentansprüche

1. Vorrichtung zum Eintauchen (1) von Wafern (P), welche Stäbe zum Halten (3) der Wafer, mindestens einen modulierbaren Haltestab (6) sowie zwei Endflansche (2), welche die Stäbe zum Halten (3) der Wafer tragen, umfasst, wobei jeder Endflansch (2) mindestens eine Nut (5) zum Aufnehmen des mindestens einen modulierbaren Haltestabes (6) umfasst, der dafür ausgelegt ist, durch Gleiten in den Nuten (5) der zwei Flansche auf einer einstellbaren Höhe positioniert zu werden, **dadurch gekennzeichnet, dass** der mindestens eine modulierbare Haltestab (6) jeweils zwei gegenüberliegende Reihen von Zähnen (9) zur Trennung der Wafer umfasst.

2. Vorrichtung nach dem vorhergehenden Anspruch, wobei die Haltestäbe (3) gezahnt sind und jeweils eine einzige Reihe von Zähnen (9) zur Trennung der Wafer umfassen.

3. Vorrichtung nach einem der vorhergehenden Ansprüche, wobei jeder Endflansch (2) eine einzige Nut (5) umfasst.

4. Vorrichtung nach einem der vorhergehenden Ansprüche, wobei jeder Endflansch (2) mehrere Nuten (5), insbesondere zwei Nuten (5), umfasst.

5. Vorrichtung nach einem der vorhergehenden Ansprüche, welche dafür ausgelegt ist, mehrere Reihen (R) von Wafern (P) aufzunehmen, insbesondere zwei, drei oder vier.

6. Vorrichtung nach einem der vorhergehenden Ansprüche, welche seitliche Haltestäbe (3) umfasst, insbesondere zwei Gruppen von seitlichen Haltestäben, eine auf jeder Seite der in der Vorrichtung (1) aufgenommenen Wafer (P).

7. Vorrichtung nach dem vorhergehenden Anspruch, wobei eine Gruppe von seitlichen Haltestäben (3) mindestens zwei seitliche Haltestäbe (3) umfasst, insbesondere zwei oder drei.

8. Vorrichtung nach einem der vorhergehenden Ansprüche, welche untere Haltestäbe (3) umfasst, insbesondere zwei, die an einer unteren Position unterhalb der Wafer angeordnet sind, um diese zu stützen.

9. Vorrichtung nach einem der vorhergehenden Ansprüche, welche mindestens einen oberen Haltestab (3) umfasst, insbesondere einen oder zwei, der an einer oberen Position oberhalb der Wafer (P) angeordnet ist, um diese zu halten.

10. Vorrichtung nach einem der vorhergehenden Ansprüche, wobei der oder die modulierbaren Haltestäbe (6) dafür ausgelegt sind, auf den Wafern (P) zu ruhen und dabei durch einen Endanschlag (11) an den Endflanschen (2) gehalten zu werden, welcher eiförmig sein kann.

11. Vorrichtung nach einem der vorhergehenden Ansprüche, wobei der oder die modulierbaren Haltestäbe (6) durch ein Befestigungsorgan (12) an den Endflanschen (2) befestigt sind.

12. Vorrichtung nach einem der vorhergehenden Ansprüche, wobei die Haltestäbe (3) einen von einer Beschichtung umgebenen Kern umfassen, wobei der Kern insbesondere aus Edelstahl besteht.

13. Vorrichtung nach einem der vorhergehenden Ansprüche, wobei die Endflansche (2) PVDF umfassen.

14. Verfahren zum Füllen einer Vorrichtung zum Eintauchen (1) nach einem der vorhergehenden Ansprüche, wobei:
(i) eine erste Reihe (R) von Wafern (P) in der Vorrichtung zum Eintauchen (1) angeordnet wird,
(ii) mindestens ein modulierbarer Haltestab (6), der mindestens zwei Reihen von Zähnen (9) umfasst, oberhalb der ersten Reihe (R) von Wafern (P) angeordnet wird, und
(iii) eine zweite Reihe (R) von Wafern (P) in der Vorrichtung zum Eintauchen (1) oberhalb des oder der modulierbaren Haltestäbe (6) angeordnet wird.

## Claims

1. Immersion device (1) for immersing wafers (P), comprising retaining bars (3) for retaining the wafers, at least one variable retaining bar (6) and two end plates (2) bearing said retaining bars (3) for retaining the wafers, each end plate (2) comprising at least one groove (5) for receiving said at least one variable retaining bar (6) that is configured to be positioned at a height that can be adjusted by sliding in the grooves (5) in the two plates, **characterized in that** said at least one variable retaining bar (6) comprises in each case two opposing rows of teeth (9) for separating the wafers.

2. Device according to the preceding claim, the retaining bars (3) being toothed and each comprising a single row of teeth (9) for separating the wafers.

3. Device according to either one of the preceding claims, each end plate (2) comprising a single groove (5) .

4. Device according to any one of the preceding claims, each end plate (2) comprising a plurality of grooves (5), in particular two grooves (5).

5. Device according to any one of the preceding claims, which is configured to receive a plurality of rows (R) of wafers (P), in particular two, three or four.

6. Device according to any one of the preceding claims, comprising lateral retaining bars (3), in particular two groups of lateral retaining bars, one on each side of the wafers (P) received in the device (1).

7. Device according to the preceding claim, a group of lateral retaining bars (3) comprising at least two lateral retaining bars (3), in particular two or three.

8. Device according to any one of the preceding claims, comprising lower retaining bars (3), in particular two, which are placed in a lower position below the wafers, in order to support the latter.

9. Device according to any one of the preceding claims, comprising at least one upper retaining bar (3), in particular one or two, which is placed in an upper position above the wafers (P), in order to retain the latter.

10. Device according to any one of the preceding claims, the one or more variable retaining bars (6) being configured to rest on the wafers (P) while being retained at the end plates (2) by an end stop (11), which may have an ovoid shape.

11. Device according to any one of the preceding claims, the one or more variable retaining bars (6) being fastened to the end plates (2) by a fastening member (12) .

12. Device according to any one of the preceding claims, the retaining bars (3) comprising a core surrounded by a coating, the core being, in particular, made from stainless steel.

13. Device according to any one of the preceding claims, wherein the end plates (2) comprise PVDF.

14. Method for filling an immersion device (1) according to any one of the preceding claims, wherein:
(i) a first row (R) of wafers (P) is placed in the immersion device (1),
(ii) at least one variable retaining bar (6), which comprises at least two rows of teeth (9), is placed above the first row (R) of wafers (P), and
(iii) a second row (R) of wafers (P) is placed in the immersion device (1) above the one or more variable retaining bars (6).
